# EUROPÄISCHE PATENTSCHRIFT

(11) **EP 0 430 133 B1**
(45) Veröffentlichungstag und Bekanntmachung des Hinweises auf die Patenterteilung: **07.09.1994**
(21) Anmeldenummer: 90122537.5
(22) Anmeldetag: 26.11.1990
(51) Int. Cl.: H01L 29/08, H01L 29/743, H01L 29/91

(54) **Leistungs-Halbleiterbauelement mit Emitterkurzschlüssen**
Power semiconductor device having emitter shorts
Dispositif semi-conducteur de puissance comportant des courts-circuits d'émetteur

(30) Priorität: 28.11.1989 DE 3939324
(43) Veröffentlichungstag der Anmeldung: 05.06.1991
(73) Patentinhaber: EUPEC Europäische Gesellschaft für Leistungshalbleiter mbH & Co. KG, D-59581 Warstein (DE)
(72) Erfinder: Voss, Peter, Dr.-Ing., W-8000 München 81 (DE)
(74) Vertreter: Fuchs, Franz-Josef, Dr.-Ing.

(56) Entgegenhaltungen:
- DE-A- 3 631 136
- FR-A- 2 456 389
- 19TH ANNUAL IEEE POWER ELECTRONICS SPECIALISTS CONFERENCE, TECHNICAL DIGEST,(PESC'88 RECORD), Kyoto, 11. - 14. April 1988, Band 2, Seiten 903-907, IEEE,New York, US; T. OGURA et al.: "Low switching loss, high power gate turn-offthyristors (GTOS) with N-buffer and new anode short structure"
- Patent Abstracts of Japan, Vol. 5, Nr. 133 (E-71) 25. August 1981 (JP-A-56-67 970)

## Beschreibung

Die Erfindung bezieht sich auf ein Halbleiterbauelement mit einem Halbleiterkörper mit einer schwach dotierten Mittelzone und einer daran anschließenden stärker dotierten Außenzone vom ersten Leitungstyp mit den Merkalen:
a)in der Außenzone sind an eine erste Oberfläche des Halbleiterkörpers angrenzende Zonen vom zweiten Leitungstyps und weitere Zonen vom ersten Leitungstyp angeordnet,
b)die weiteren Zonen sind höher dotiert als die Außenzone,
c)die weiteren Zonen haben geringe Tiefe als die Zonen vom zweiten Leitungstyp,
d)mit Kurzschlüssen zwischen der Außenzone und den Zonen vom zweiten Leitungstyp.

Ein solches Halbleiterbauelement ist z.B. in der DE-A-36 31 136 beschrieben worden. Hier haben die Zonen des zweiten Leitungstyps in Verbindung mit den weiteren Zonen den Zweck, beim Abschalten Ladungsträger nachzuliefern, so daß ein sanftes Abschalten der Diode möglich ist.

Katodenseitige Kurzschlüsse bei Leistungsdioden sind z.B. auch in der DE-A-25 06 102 und in "Japan Annuals Reviews in Electronics, Computers and Telecommunications" 13, 1984, Seite 75 bis 87 beschrieben worden.

Die genannten Kurzschlüsse sind häufig auch für die Funktion von Thyristoren unentbehrlich. Bei symmetrischen Thyristoren sind sie katodenseitig angeordnet, bei GTO-Thyristoren anodenseitig (man vergleiche "Patent Abstracts of Japan", JP-A-56 06 79 70 vom 08. Juni 1981).

Für die Anwendung in Stromrichtern und Choppern ist eine möglichst niedrige Speicherladung im Halbleiterbauelement erwünscht. Es ist bekannt, die Speicherladung durch Eindiffusion von Metallen herabzusetzen. Die Eindiffusion von Metallen führt zu einer generellen Herabsetzung der Trägerlebensdauer auch in der schwach dotierten, von beiden Ladungsträgerarten überschwemmten Mittelzone. Dies führt zu einem starken "Durchhängen" der Ladungsträgerkonzentration im Halbleiterkörper.

Für bestimmte Anwendungen kann es sinnvoller sein, die Konzentration der Ladungsträger durch Verschlechterung des Emitterwirkungsgrades herabzusetzen. Davon macht man bei GTO-Thyristoren in der Weise Gebrauch, daß man die erwähnten Kurzschlüsse anodenseitig anordnet. Anodenseitig deswegen, damit in der Nähe des anodenseitigen Emitters von vornherein nur wenig Ladungsträger vorhanden sind. Die anodenseitigen Kurzschlüsse beim GTO-Thyristor sind in ähnlicher Weise aufgebaut wie die katodenseitigen Kurzschlüsse beim symmetrischen Thyristor. Da meistens die niedrig dotierte n-Basis kurzgeschlossen wird, sind die Kurzschlußgebiete üblicherweise erheblich größer als bei einem katodenseitig kurzgeschlossenen Thyristor.

Ist anodenseitig wie beim GTO-Thyristor nach "Patent Abstracts..." eine stark dotierte Stoppschicht versehen, so kann die Wirkung der Kurzschlüsse aufgrund der hohen Querleitfähigkeit der Stoppschicht unzureichend sein. Werden die Kurzschlüsse vergrößert, so können sich jedoch die Zündströme stark erhöhen.

Ziel der Erfindung ist es, ein Halbleiterbauelement der erwähnten Gattung so weiterzubilden, daß eine gute Kurzschlußwirkung ohne Beeinträchtigung der Zündfähigkeit möglich wird.

Dieses Ziel wird dadurch erreicht, daß die Zonen des zweiten Leitungstyps die weiteren Zonen derart überlappen, daß nur ein Teil der zur ersten Oberfläche parallelen Fläche der weiteren Zonen an die Außenzone vom zweiten Leitungstyps mit mindestens einer Elektrode versehen sind, die diese Zonen entweder unmittelbar oder über eine Schaltungsanordnung zur Ausbildung der genannten Kurzschlüsse elektrisch miteinander verbindet.

Weiterbildungen der Erfindung sind Gegenstand der Unteransprüche.

Die Erfindung wird anhand von Ausführungsbeispielen in Verbindung mit den Figuren 1 bis 7 näher erläutert. Es zeigen
Figur 1 einen Querschnitt durch einen symmetrischen Thyristor gemäß Erfindung,
Figur 2 und 3 einen teilweisen Schnitt durch den Thyristor nach Figur 1 mit eingezeichneten Stromläufen während bestimmter Betriebsphasen,
Figur 4 eine Abwandlung des Thyristor nach Figur 3,
Figur 5 ein weiteres Ausführungsbeispiel
FIG 6 den Schnitt durch eine Diode und
FIG 7 den Schnitt durch einen GTO-Thyristor mit Kurzschlüssen gemäß der Erfindung.

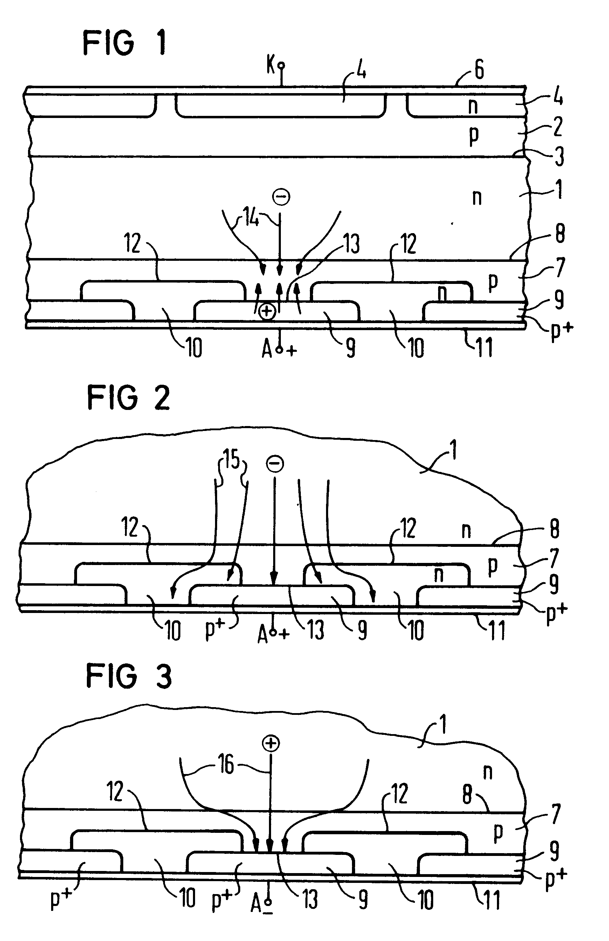

Der Thyristor nach FIG 1 ist bezüglich der Sperrfähigkeit symmetrisch aufgebaut. Er enthält eine n-dotierte Mittelzone 1, an die eine p-dotiert Katodenbasiszone 2 angrenzt. In der Katodenbasiszone 2 sind n-dotierte Katodenemitterzonen 4 eingebettet. Die Zonen 2 und 4 sind durch eine Katodenelektrode 6 kontaktiert, wodurch der von einem symmetrischen Thyristor her bekannte katodenseitige Kurzschluß entsteht. Auf der Anodenseite der Emitterzone 1 schließt sich eine p-dotierte anodenseitige Außenzone 7 an. Bei einem symmetrischen Thyristor wirkt sie als Emitterzone. In der Außenzone 7 sind weitere Zonen 9 vom Leitungstyp der Außenzone 7 eingebettet. Ihre Dotierung ist jedoch höher als die der Zone 7. Weiterhin sind in der Zone 7 n-dotierte Zonen 10 eingebettet, die eine größere Tiefe als die Zonen 9 und eine kleinere Tiefe als die Außenzone 7 haben. Die Zonen 10 überlappen die weiteren Zonen 9 derart, daß ein Teil der Zonen 9 direkt an die Außenzone 7 angrenzt. Die Übergänge zwischen den Zonen 9 und der Zone 7 sind mit 13, die pn-Übergänge zwischen den Zonen 10 und der Zone 7 sind mit 12 und pn-Ubergang zwischen den Zonen 1 und 7 ist mit 8 bezeichnet. Die Dicke und die Dotierung sowie der Verlauf der Dotierung über ihre Dicke ist auf beiden Seiten gleich. Die pn-Übergänge 3 und 8 nehmen daher die gleiche Sperrspannung auf.

In FIG 1 ist der Weg, den die negativen Ladungsträger bei geringer Stromdichte zur Anode A nehmen, durch Pfeile 14 symbolisiert. Eine solch geringe Stromdichte liegt z. B. während des Zündens vor. Die negativen Ladungsträger fließen dabei aus der Zone 1 überwiegend direkt in die Zone 7 und in die Zonen 9. Die pn-Übergänge 12 sind gesperrt und der anodenseitige Kurzschluß ist weitgehend wirkungslos.

Bei höherer Stromdichte werden die pn-Übergänge 12 mit Ladungsträgern überschwemmt und die negativen Ladungsträger fließen sowohl in die Zonen 9 als auch über die pn-Übergänge in die Zonen 10. Hierbei sind die zwischen den Zonen 9 und 10 über die Anodenelektrode 11 gebildeten Kurzschlüsse wirksam. Die Kurzschlüsse bewirken eine Verschlechterung des Emitterwirkungsgrades der Außenzone 7. Damit werden, gemessen an einem Thyristor ohne anodenseitige Kurzschlüsse, von ihr weniger positive Ladungsträger in die Mittelzone 1 emittiert. Daß heißt, daß die anodenseitige Konzentration an Minoritätsträgern herabgesetzt wird, was einer Verminderung der Trägerspeicherladung entspricht.

In FIG 3 ist der anodenseitige Weg der Minoritätsladungsträger im Kommutierungsfall dargestellt, wenn an der Anode A negatives Potential gegenüber der Katode anliegt. Die positiven Ladungsträger werden, wie die Pfeile 16 symbolisieren, aus der Mittelzone 1 in die Zone 9 abgesaugt und der pn-Übergang 8 nimmt Sperrspannung auf. Die Verhältnisse sind ähnlich wie während derjenigen Phase in einem normalen Thyristor, bei der er in Vorwärtsrichtung Sperrspannung aufnimmt, z. B. während einer du/dt- oder Freiwerdebelastung.

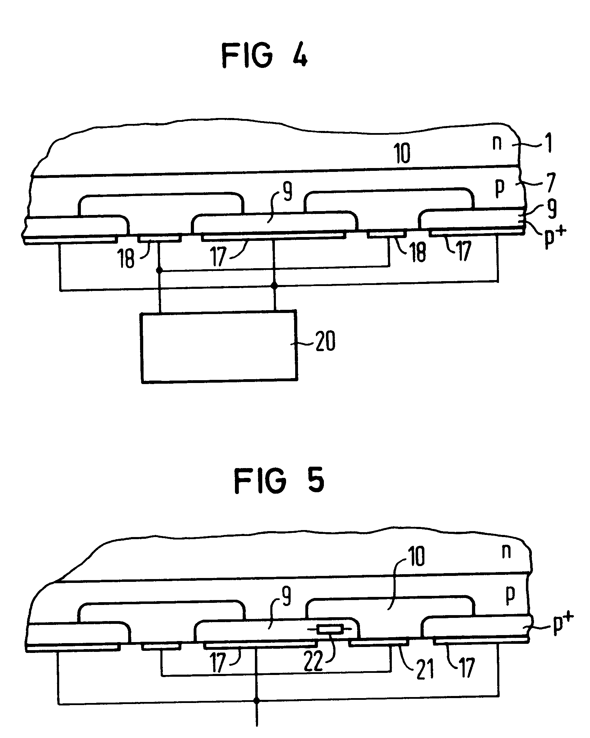

Beim Ausführungsbeispiel nach FIG 1 bis 3 wurde der Kurzschluß dadurch gebildet, daß die Zonen 9 und 10 unmittelbar durch die Anodenelektrode 11 verbunden sind. Es ist jedoch auch möglich, wie in FIG 4 gezeigt, die Zonen 9 und 10 durch elektrisch voneinander getrennte Elektroden 17 bzw. 18 zu kontaktieren. Die Elektroden 17 werden mit den Elektroden 18 über eine Schaltungsanordnung 20 verbunden. Diese kann z. B. einen Widerstand, einen Schalter, ein passives oder steuerbares Halbleiterbauelement oder auch eine komplexe Schaltungsanordnung enthalten, mit deren Hilfe der Kurzschluß gezielt abhängig vom Betriebszustand eingeschaltet wird.

Das Ausführungsbeispiel nach FIG 5 unterscheidet sich von dem nach FIG 4 und 1 bis 3 im wesentlich dadurch, daß die Zonen 9 außer durch die Elektroden 17 durch Elektroden 21 kontaktiert werden, wobei die Elektrode 21 auch die Zonen 10 kontaktiert. Die Elektroden 17 und 22 haben einen Abstand voneinander. Der entsprechende Teil der Zone 9 bildet somit einen integrierten Widerstand 22, so daß zwischen den Zonen 9 und 10 kein direkter Kurzschluß, sondern eine Widerstandsverbindung besteht.

Die für einen symmetrischen Thyristor beschriebenen anodenseitigen Kurzschlüsse können in gleicher weise auch für Dioden verwendet werden, wenn auf der Anodenseite die Trägerkonzentration abgesenkt werden soll, um z. B. ein weiches Abschaltverhalten zu erzielen.

Die für einen symmetrischen Thyristor beschriebenen anodenseitigen Kurzschlüsse können in abgewandelter Form auch bei speziellen Dioden, die z. B. als Freilaufdioden für GTO-Thyristoren eingesetzt und auf der Katodenseite verwendet werden. Bei solchen Dioden muß der "Schweifstrom" schnell abklingen, um hohe Verluste zu vermeiden. Sollen die Ladungträgerdichten sowohl auf der Katodenseite als auch auf der Anodenseite abgesenkt werden (Kleinmann-Fall), so können beide Kurzschlußarten gleichzeitig eingesetzt werden.

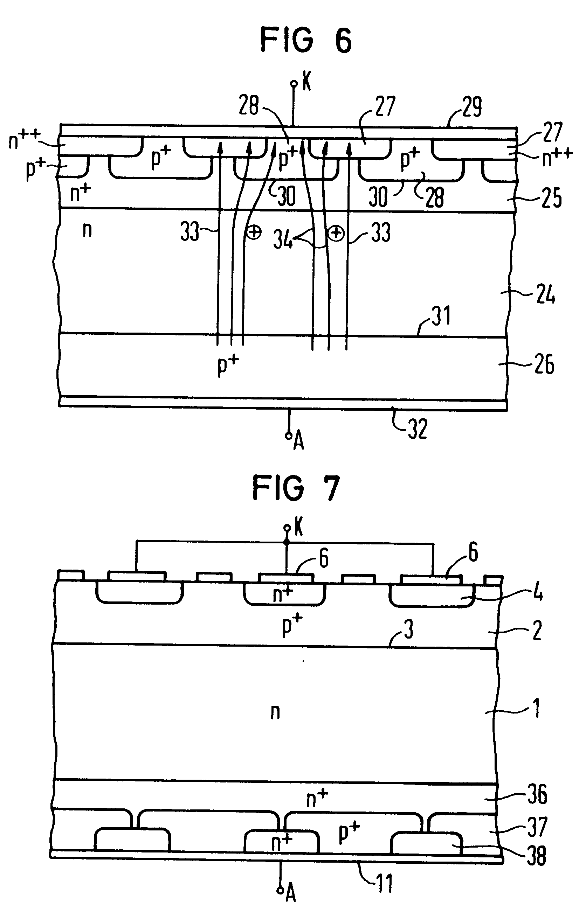

Die Diode nach FIG 6 hat eine Mittelzone 24, an die sich eine katodenseitige Außenzone 25 als Stopschicht und eine anodenseitige Außenzone 26 anschließt. Die katodenseitige Außenzone hat den gleichen Leitungstyp wie die Mittelzone 26, die Zone 26 ist entgegengesetzt dotiert. In die Außenzone 25 sind Zonen 27 vom gleichen Leitungstyp wie die Außenzone 25 eingebettet. Sie haben höhere Dotierung als jene. Außerdem sind in die Außenzone 25 Zonen 28 von der Außenzone 25 entgegengesetzten Leitungstyp eingebettet. Entsprechend wie beim Thyristor haben diese Zonen eine größere Tiefe als die Zonen 27 und eine geringere Tiefe als die Außenzone 25. Katodenseitig ist die Diode durch eine Katodenelektrode 29 und anodenseitig durch eine Anodenelektrode 32 kontaktiert. Zwischen den Zonen 24 und 26 liegt ein pn-Übergang 31, zwischen den Zonen 28 und der Zone 25 liegen pn-Übergänge 30.

Wird die Diode in Durchlaßrichtung betrieben, so fließen analog zum Thyristor positive Ladungsträger aus der Anodenemitterzone 26 durch die Mittelzone 24 entsprechend der Pfeile 33 durch die Zone 27 zur Katode. Bei höherer Stromdichte werden die pn-Übergänge 30 überschwemmt und der Strom nimmt seinen Weg entsprechend der Pfeile 34 auch über die Zonen 28 zur Katode. Damit wird der Emitterwirkungsgrad des katodenseitigen, durch die Außenzone 25 gebildeten Emitters der Diode und damit die Trägerspeicherladung herabgesetzt.

Die Erfindung läßt sich auch für GTO-Thyristoren mit anodenseitiger Stopschicht verwenden. GTO-Thyristoren ohne eine solche Stopschicht haben einfache anodenseitige Kurzschlüsse, die durch Zonen gebildet werden, deren Leitungstyp dem der anodenseitigen Emitterzone entgegengesetzt ist. Liegt zwischen dieser Emitterzone und der Mittelzone eine hochdotierte Stopschicht, wird die anodenseitige Querleitfähigkeit höher. Um den GTO-Thyristor trotzdem mit niedrigem Strom zünden zu können, müssen die die Kurzschlüsse bildenden Bereiche einen großen Abstand voneinander haben. Ähnlich wie beim normalen Katodenkurzschluß werden die Kurzschlüsse dadurch aber bei hohen Stromdichten weitgehend wirkungslos.

In FIG 7 ist ein GTO-Thyristor gezeigt, bei dem die Kurzschlußwirkung erhalten bleibt. An die Mittelzone 1 schließt sich anodenseitig eine Außenzone 36 an, die als Stopschicht wirkt. Die Stopschicht hat den gleichen Leitungstyp wie die Mittelzone 1, aber höhere Dotierung als diese. In die Stopschicht 36 sind Zonen 37 des entgegengesetzten Leitungstyps eingebettet, die als Anodenemitterzone dienen. In die anodenseitige Oberfläche sind weitere Zonen 38 eingebettet, die den gleichen Leitungstyp wie die Stopschicht 36 haben. Sie werden von den Zonen 38 überlappt. Die Zonen 37, 38 sind gemeinsam durch die Anodenelektrode 11 kontaktiert.

Die Fläche der Zonen 37 beträgt mindestens 90 %, z. B. 98 % der anodenseitigen Fläche des Halbleiterkörpers. Dadurch nimmt der Strom beim Zünden des GTO-Thyristors einen weg entsprechend FIG 1 durch die Zone 36 über die Zonen 38 zur Elektrode 11. D. h., daß bei geringer Stromdichte die den Kurzschluß bewirkenden Bereiche 2 % der Anodenfläche betragen. Der Zündstrom bleibt damit entsprechend niedrig. Die weiteren Zonen 38 können insgesamt eine Fläche von 10 bis 70 % der Anodenfläche haben. Bei hoher Stromdichte nimmt der Löcherstrom dann einen Weg entsprechend FIG 2, wobei z. B. ein Löcherstrom in Höhe von 50 % der Gesamtstroms über die Kurzschlüsse abfließt und die anodenseitige Trägerladungsdichte bleibt entsprechend gering.

## Patentansprüche

1. Halbleiterbauelement mit einem Halbleiterkörper mit einer schwach dotierten Mittelzone (1) und einer daran anschließenden stärker dotierten Außenzone (7) vom ersten Leitungstyp mit den Merkmalen:
a)in der Außenzone (7) sind an eine erste Oberfläche des Halbleiterkörpers angrenzende Zonen (10) vom zweiten Leitungstyp und weitere Zonen (9) vom ersten Leitungstyp angeordnet,
b)die weiteren Zonen (9) sind höher dotiert als die Außenzone,
c)die weiteren Zonen (9) haben geringere Tiefe als die Zonen (10) vom zweiten Leitungstyp,
d)mit Kurzschlüssen zwischen der Außenzone (7) und den Zonen (10) vom zweiten Leitungstyp,
**dadurch gekennzeichnet,** daß die Zonen (10) des zweiten Leitungstyps die weiteren Zonen (9) derart überlappen, daß nur ein Teil der zur ersten Oberfläche parallelen Fläche der weiteren Zonen (9) an die Außenzone (7) grenzt und daß die weiteren Zonen und die Zonen vom zweiten Leitungstyp mit mindestens einer Elektrode (11) versehen sind, die diese Zonen entweder unmittelbar oder über eine Schaltungsanordung zur Ausbildung der genannten Kurzschlüsse elektrisch miteinander verbindet.

2. Halbleiterbauelement nach Anspruch 1,
**dadurch gekennzeichnet**, daß die Außenzone (7) die anodenseitige Emitterzone eines symmetrisch sperrenden Thyristors ist,

3. Halbleiterbauelement nach Anspruch 2,
**dadurch gekennzeichnet**, daß die Elektroden (17) der weiteren Zonen (9) mit den Elektroden (18) der Zonen (10) vom zweiten Leitungstyp über einen Widerstand verbunden sind.

4. Halbleiterbauelement nach Anspruch 2,
**dadurch gekennzeichnet**, daß die Elektroden der weiteren Zonen mit den Elektroden der Zonen vom zweiten Leitungstyp über einen steuerbaren Schalter miteinander verbunden sind.

5. Halbleiterbauelement nach Anspruch 2,
**dadurch gekennzeichnet**, daß die Elektroden der weiteren Zonen mit den Eletroden der Zonen vom zweiten Leitungstyp über ein Halbleiterbauelement miteinander verbunden sind.

6. Halbleiterbauelement nach Anspruch 1,
**dadurch gekennzeichnet**, daß die Außenzone (7) die anodenseitige Emitterzone einer Diode ist.

7. Halbleiterbauelement nach Anspruch 1,
**dadurch gekennzeichnet**, daß die Außenzone (25) die katodenseitige Stopschicht einer Diode ist.

8. Halbleiterbauelement nach Anspruch 1,
**dadurch gekennzeichnet**, daß die Außenzone (36) die anodenseitige Stopschicht eines GTO-Thyristors ist.

9. Halbleiterbauelement nach Anspruch 8,
**dadurch gekennzeichnet**, daß die Summe der zur ersten Oberfläche parallelen Flächen der Zonen des zweiten Leitungstyps (37) mindestens 90 % der anodenseitigen Fläche des Halbleiterkörpers beträgt und daß die Summe der zur ersten Oberfläche parallelen Flächen der weiteren Zonen (38) zwischen 10 und 70 % der anodenseitigen Fläche des Halbleiterkörpers beträgt.

10. Halbleiterbauelement nach Anspruch 6 oder 7,
**dadurch gekennzeichnet**, daß sowohl die Katodenseite als auch die Anodenseite mit Kurzschlüssen versehen ist.

## Claims

1. Semiconductor component comprising a semiconductor body having a weakly doped middle zone (1) and, adjacent thereto, a more highly doped outer zone (7) of the first conductivity type, having the features:
a) zones (10) of the second conductivity type which adjoin a first surface of the semiconductor body and further zones (9) of the first conductivity type are arranged in the outer zone (7),
b) the further zones (9) are more highly doped than the outer zone,
c) the further zones (9) have a lesser depth than the zones (10) of the second conductivity type, and
d) having shorts between the outer zone (7) and the zones (10) of the second conductivity type,
characterized in that the zones (10) of the second conductivity type overlap the further zones (9) in such a way that only a portion of the area, parallel to the first surface, of the further zones (9) adjoins the outer zone (7), and in such a way that the further zones and the zones of the second conductivity type are provided with at least one electrode (11) which connects these zones electrically to one another either directly or via a circuit arrangement for forming the said shorts.

2. Semiconductor component according to Claim 1, characterized in that the outer zone (7) is the anode-side emitter zone of a symmetrically blocking thyristor.

3. Semiconductor component according to Claim 2, characterized in that the electrodes (17) of the further zones (9) are connected to the electrodes (18) of the zones (10) of the second conductivity type via a resistor.

4. Semiconductor component according to Claim 2, characterized in that the electrodes of the further zones are connected to the electrodes of the zones of the second conductivity type via a controllable switch.

5. Semiconductor component according to Claim 2, characterized in that the electrodes of the further zones are connected to the electrodes of the zones of the second conductivity type via a semiconductor component.

6. Semiconductor component according to Claim 1, characterized in that the outer zone (7) is the anode-side emitter zone of a diode.

7. Semiconductor component according to Claim 1, characterized in that the outer zone (25) is the cathode-side stop layer of a diode.

8. Semiconductor component according to Claim 1, characterized in that the outer zone (36) is the anode-side stop layer of a GTO thyristor.

9. Semiconductor component according to Claim 8, characterized in that the sum of the areas, parallel to the first surface, of the zones of the second conductivity type (37) amounts to at least 90 % of the anode-side area of the semiconductor body, and in that the sum of the areas, parallel to the first surface, of the further zones (38) amounts to between 10 and 70 % of the anode-side area of the semiconductor body.

10. Semiconductor component according to Claim 6 or 7, characterized in that both the cathode side and the anode side are provided with shorts.

## Revendications

1. Composant à semiconducteurs comportant un corps semiconducteur pourvu d'une zone centrale faiblement dopée (1) et d'une zone extérieure plus fortement dopée (16), qui se raccorde à la zone centrale et possède un premier type de conductivité, présentant les particularités suivantes:
a) dans la zone extérieure (7) sont disposées des zones (10) possédant un second type de conductivité et qui jouxtent une première surface du corps semiconducteur, et d'autres zones (9) possédant le premier type de conductivité,
b) les autres zones (9) sont plus fortement dopées que la zone extérieure,
c) les autres zones (9) possèdent une profondeur inférieure à celle des zones (10) possédant le second type de conductivité,
d) avec des courts-circuits entre la zone extérieure (7) et les zones (10) possédant le second type de conductivité,
caractérisé par le fait que les zones (10) possédant le second type de conductivité chevauchent les autres zones (9) de telle sorte que seule une partie de la surface, qui est parallèle à la première surface, des autres zones (9) jouxte la zone extérieure (7) et que les autres zones et les zones possédant le second type de conductivité comportent au moins une électrode (11), qui relie électriquement entre elles ces zones soit directement, soit par l'intermédiaire d'un montage servant à former lesdits courts-circuits.

2. Composant à semiconducteurs suivant la revendication 1, caractérisé par le fait que la zone extérieure (7) est la zone d'émetteur, située côté anode, d'un thyristor exécutant un blocage symétrique.

3. Composant à semiconducteurs suivant la revendication 2, caractérisé par le fait que les électrodes (17) des autres zones (9) sont reliées aux électrodes (18) des zones (10) possédant le second type de conductivité, par l'intermédiaire d'une résistance.

4. Composant à semiconducteurs suivant la revendication 2, caractérisé par le fait que les électrodes des autres zones sont reliées entre elles aux électrodes des zones du second type de conductivité, par l'intermédiaire d'un interrupteur commandable.

5. Composant à semiconducteurs suivant la revendication 2, caractérisé par le fait que les électrodes des autres zones sont reliées aux électrodes des zones du second type de conductivité par l'intermédiaire d'un composant à semiconducteurs.

6. Composant à semiconducteurs suivant la revendication 1, caractérisé par le fait que la zone extérieure (7) est la zone d'émetteur, située côté anode, d'une diode.

7. Composant à semiconducteurs suivant la revendication 1, caractérisé par le fait que la zone extérieure (25) est la couche d'arrêt, située côté cathode, d'une diode.

8. Composant à semiconducteurs suivant la revendication 1, caractérisé par le fait que la zone extérieure (36) est la couche d'arrêt, située côté anode, d'un thyristor GTO.

9. Composant à semiconducteurs suivant la revendication 8, caractérisé par le fait que la somme des surfaces, qui sont parallèles à la première surface, des zones possédant le second type de conductivité (37) est égale à au moins 90 % de la surface, située du côté anode, du corps semiconducteur et que la somme des surfaces, parallèles à la première surface, des autres zones (38) est comprise entre 10 et 70 % de la surface, située côté anode, du corps semiconducteur.

10. Composant à semiconducteurs suivant la revendication 6 ou 7, caractérisé par le fait qu'aussi bien le côté cathode que le côté anode comportent des courts-circuits.
